# EUROPÄISCHE PATENTSCHRIFT

(11) **EP 2 088 672 B1**
(45) Veröffentlichungstag und Bekanntmachung des Hinweises auf die Patenterteilung: **12.09.2012**
(21) Anmeldenummer: 09007134.1
(22) Anmeldetag: 10.01.2007
(51) Int. Cl.: H03H 11/24, H03H 11/28, H03H 11/46

(54) **Schaltung zum Einstellen einer Impedanz**
Switch for setting an impedance
Embrayage destiné à régler une impédance

(30) Priorität: 31.01.2006 DE 102006004624; 22.09.2006 DE 102006045279
(43) Veröffentlichungstag der Anmeldung: 12.08.2009
(62) Teilanmeldung aus: 07711142.5
(73) Patentinhaber: Micro-Epsilon Messtechnik GmbH & Co. KG, 94496 Ortenburg (DE)
(72) Erfinder: Hrubes, Franz, 94086 Bad Griesbach (DE)
(74) Vertreter: Ullrich & Naumann

(56) Entgegenhaltungen:
- EP-A- 0 564 164
- EP-A- 0 656 542
- WO-A-90/12274
- DE-A1- 3 151 082
- DE-A1- 3 901 314
- DE-A1- 4 327 712
- JP-A- 60 259 014
- US-A- 4 350 964
- US-A- 5 420 507

## Beschreibung

Die Erfindung betrifft eine Schaltung zum Einstellen einer Impedanz zwischen zwei Polen, wobei die Impedanz die Eingangsimpedanz der Schaltung ist, wobei die Schaltung Verstärker und Einstellmittel umfasst, wobei mittels des/der Einstellmittel die Verstärkung mindestens eines der Verstärker verändert werden kann, wobei durch Beeinflussen des/der Einstellmittel die Impedanz zwischen den beiden Polen veränderbar ist, wobei die Schaltung eine Rückkopplungsschleife mit einer Rückkopplungsimpedanz aufweist und wobei durch Beeinflussen des/der Einstellmittel der für die Eingangsimpedanz der Schaltung wirksame Anteil der Rückkopplungsimpedanz einstellbar ist.

Einstellbare Impedanzen werden in vielen Bereichen der Schaltungstechnik benötigt und verwendet. Besonders häufig kommen sie im Zusammenhang mit anpassbaren LC-Schwingkreisen zum Einsatz und dienen dazu, den Schwingkreis auf eine gewünschte Resonanzfrequenz abzustimmen. Die Resonanzfrequenz eines LC-Schwingkreises ist durch seine Kapazitäts- und Induktivitätswerte bestimmt. Soll die Resonanzfrequenz eingestellt oder verändert werden, so müssen diese Werte geeignet beeinflusst werden. Hierfür sind aus der Praxis verschiedene Verfahren bekannt. Zum einen können Festkondensatoren bzw. -induktivitäten zu dem Schwingkreis hinzu- oder weggeschaltet werden. Zum anderen sind Trimm- oder Drehkondensatoren bzw. in ihrer Induktivität einstellbare Spulen bekannt und werden seit vielen Jahren eingesetzt. Eine weitere Möglichkeit zur Einstellung von Impedanzen bieten Kapazitätsdioden.

Problematisch sind derartige Ansätze dann, wenn das Einstellen oder der Abgleich des Schwingkreises automatisiert erfolgen soll. Es ist zwar denkbar, einzelne Festkondensatoren oder -induktivitäten mittels elektronischer Schalter in den Schwingkreis einzuschleifen oder herauszutrennen, allerdings lässt sich damit lediglich eine geringe Anzahl von diskreten Frequenzwerten einstellen. Ferner sind infolge von Bauteiltoleranzen die Frequenzen vergleichsweise ungenau einstellbar. Trimm- oder Drehkondensatoren bzw. in ihrer Induktivität einstellbare Spulen liefern zwar kontinuierliche und große Einstellbereiche, sind jedoch wegen der notwendigen mechanischen Verschiebung oder Drehung für einen automatischen Abgleich gänzlich ungeeignet. Die Kapazität von Kapazitätsdioden ist zwar automatisch und quasikontinuierlich einstellbar, ist allerdings stark nichtlinear von der Steuerspannung abhängig und weist eine große Temperaturdrift und Abhängigkeit von der Schwingkreisamplitude auf. Darüber hinaus sind kaum gut steuerbare und stabile Bauteile bekannt, die über einen größeren Bereich einstellbar sind. Erhältliche programmierbare Kapazitäten sind zwar gut steuerbar und ausreichend stabil, weisen jedoch lediglich einen Einstellbereich von wenigen Piko-Farad auf. Diese oder ähnliche Probleme treten nicht nur beim Ändern der Resonanzfrequenz von Schwingkreisen auf, sondern sind aus anderen Anwendungsbereichen, bei denen veränderbare Impedanzen Anwendung finden, ebenfalls bekannt.

Eine Schaltung zum Einstellen einer Impedanz ist in der EP 0 656 542 A2 offenbart. Bei dieser Schaltung kommt ein Verstärker mit auswählbarer Verstärkung zum Einsatz. Die Auswahl der Verstärkung erfolgt über einen multiplizierenden Verstärker, mittels dessen ein wirksamer Anteil einer Rückkopplungsimpedanz eingestellt wird.

Der vorliegenden Erfindung liegt daher die Aufgabe zugrunde, eine Schaltung der eingangs genannten Art derart auszugestalten und weiterzubilden, dass ein möglichst großer Einstellbereich einer Impedanz bei gleichzeitig guter Steuer- und/oder Programmierbarkeit erreichbar ist. Dabei soll die Schaltung einfach und kostengünstig aufzubauen sein und ein möglichst stabiles Betriebsverhalten zeigen.

Erfindungsgemäß wird die voranstehende Aufgabe durch die Merkmale des Patentanspruchs 1 gelöst. Danach ist die in Rede stehende Schaltung **dadurch** gekennzeichnet, dass die Schaltung Bestandteil eines Schwingkreises ist, dessen Schwingfrequenz oder Phasenlage durch Beeinflussen des/der Einstellmittel beeinflussbar ist.

In erfindungsgemäßer Weise ist zunächst erkannt worden, dass zum Einstellen einer Impedanz zwischen zwei Polen eine Einstellbarkeit nicht nur dadurch erreicht werden kann, dass Impedanzen zu- oder weggeschaltet oder in ihren Werten eingestellt werden. Vielmehr kann die Impedanz zwischen zwei Polen als Eingangsimpedanz einer Schaltung mit elektronischen Mitteln verändert werden. Dazu werden in der Schaltung Verstärker eingesetzt, wobei einer oder mehrere der Verstärker durch Einstellmittel in ihrer Verstärkung einstellbar sind. Alternativ oder zusätzlich könnte auch die gesamte Schaltung in der Verstärkung veränderbar sind. Durch Beeinflussen des oder der Einstellmittel verändert sich die Impedanz zwischen den beiden Polen, was bei geeigneter Dimensionierung der Verstärker und deren Beschaltung zu einer Einstellbarkeit einer Impedanz zwischen den beiden Eingangspolen genutzt werden kann. Durch geeignete Ausgestaltung der Einstellmittel kann auf diese Weise über einen großen Bereich hinweg eine Impedanz mit einfachen Mitteln verändert werden. Durch die Verwendung von Verstärkern und einfachen Einstellmitteln kann somit eine Einstellbarkeit einer Impedanz über einen größeren Bereich und eine gute Steuer- und Programmierbarkeit erreicht werden. Dabei könnten auch elektronisch einstellbare Einstellmittel verwendet werden, wodurch eine automatische Einstellung ermöglicht wird.

Erfindungsgemäß ist ferner in der Schaltung eine Rückkopplungsschleife vorgesehen, die eine Rückkopplungsimpedanz enthält. Dabei wirken die Rückkopplungsimpedanz, die Verstärker und das/die Einstellmittel derart zusammenwirken, dass durch Beeinflussen des/der Einstellmittel der für die Eingangsimpedanz der Schaltung wirksame Teil der Rückkopplungsimpedanz einstellbar ist. Dies könnte derart ausgestaltet sein, dass bei einer größer werdenden Verstärkung der wirksame Anteil der Rückkopplungsimpedanz abnimmt. So ist beispielsweise in einer derartigen Schaltung bei einem Verstärkungsfaktor von 1 die Rückkopplungsimpedanz wirkungslos. Je weiter der Verstärkungsfaktor abnimmt, umso größer würde der wirksame Anteil der Rückkopplungsimpedanz werden. Bei Erreichen eines Verstärkungsfaktors von 0 wäre die gesamte Rückkopplungsimpedanz am Eingang der Schaltung wirksam. Damit kann über einen weiten Bereich hinweg eine Impedanz gesteuert werden, wodurch die Aufgabe durch die erfindungsgemäße Schaltung gelöst ist.

Erfindungsgemäß ist ferner erkannt worden, dass die Schaltung als Bestandteil eines Schwingkreises zum Einstellen dessen Schwingfrequenz oder Phasenlage durch Beeinflussen des/der Einstellmittel einsetzbar ist.

Die Rückkopplungsimpedanz könnte aus einer oder mehrerer Kapazitäten und/oder einer oder mehrerer Induktivitäten gebildet sein. Daneben könnten ohmsche Anteile enthalten sein. Die Rückkopplungsimpedanz könnte auf die verschiedensten Arten aufgebaut sein. Hierzu stehen sämtliche aus der Praxis bekannten Impedanzen zur Verfügung. Folienkondensatoren, Kernspulen, Vielschichtkondensatoren oder Keramikkondensatoren seien lediglich als einige beispielhafte Ausgestaltungen erwähnt. Die Impedanz könnte jedoch auch als Teil einer integrierten Schaltung realisiert sein. Die Wahl der Bauteile wird in den meisten Fällen von den jeweiligen schaltungstechnischen Anforderungen abhängen.

Vorteilhafter Weise wird die Verstärkung mit einem Wert zwischen 0 und 1 gewählt werden. Zwar könnte auch ein Wert größer 1 eingestellt werden, jedoch neigt die Schaltung dann zu Schwingungen, die im Allgemeinen unerwünscht sind.

Vorzugsweise werden die Verstärker durch Operationsverstärker realisiert. Operationsverstärker weisen den Vorteil auf, dass mit ihnen vergleichsweise einfach kompakte Schaltungen aufbaubar sind. Allerdings könnten, insbesondere bei höheren Frequenzen, auch andere Verstärker, wie beispielsweise einfache Transistorverstärker, zum Einsatz kommen.

Die Schaltung weist an einem oder an beiden Polen jeweils einen Verstärker auf, der als Pufferverstärker wirkt. Dieser Pufferverstärker dient dazu, das Eingangspotential an dem Pol unabhängig von dem Ausgang werden zu lassen. Liegt das an einem Pol anliegende Potential auf Festpotential, so kann im Allgemeinen auf die Verwendung eines Pufferverstärkers verzichtet werden. Im Allgemeinen wird jedoch mindestens einer der Pole über einen Pufferverstärker verfügen.

Das/die Einstellmittel könnten manuell, elektrisch, elektronisch und/oder digital einstellbar sein. Eine manuelle Einstellbarkeit kann insbesondere dann interessant sein, wenn auf eine Einstellelektronik verzichtet werden soll oder kann und lediglich vergleichsweise selten die Impedanz verändert werden muss. Eine elektrische, elektronische oder digitale Einstellbarkeit ist insbesondere bei einer automatischen oder automatisierten Einstellung der Impedanz notwendig. Diese Einstellmittel können durch sämtliche aus der Praxis bekannten Vorrichtungen realisiert sein. Je nach gewünschtem Anwendungsgebiet und gewünschter Einstellgenauigkeit können die Einstellmittel über eine kontinuierliche Einstellbarkeit verfügen oder in Stufen oder quasikontinuierlich veränderbar sein. Welche Einstellmittel letztendlich gewählt werden, ist von dem jeweils gewünschten Einsatzbereich und den daraus hervorgehenden Anforderungen abhängig.

Eine mögliche Ausgestaltung der Einstellmittel bestünde in dem Einsatz von Potentiometern. Diese könnten auf die verschiedensten aus der Praxis bekannten Weisen ausgestaltet sein. Dabei wäre sowohl eine analoge als auch digitale Ausgestaltung denkbar.

Eine weitere Möglichkeit zur Realisierung eines Einstellmittels bestünde darin, dass ein Einstellmittel mit einem zugeordneten Verstärker als strom- oder spannungsgesteuerter Verstärker verwirklicht ist. Ein stromgesteuerter Verstärker (IGA) würde mit einer einstellbaren Stromquelle eingestellt werden. Entsprechend wäre zur Einstellung eines spannungsgesteuerten Verstärkers (VGA) eine steuerbare Spannungsquelle vorgesehen. Die Strom- bzw. Spannungsquelle ließe sich wiederum auf die verschiedensten aus der Praxis bekannten Arten einstellen. So könnte die Strom- bzw. Spannungsquelle als digital oder analog gesteuerte Quelle ausgestaltet sein.

Ein Einstellmittel könnte jedoch auch durch einen multiplizierenden Digital-Analog-Wandler gebildet werden. In diesem Fall könnte beispielsweise der Multiplikationsfaktor als digitale Größe in das System eingegeben werden und mit diesem Faktor die Eingangsgröße multipliziert werden.

Darüber hinaus sind viele weitere Einstellmittel denkbar. Aus der Praxis ist hierzu eine Vielzahl von Möglichkeiten bekannt.

Ferner könnten verschiedene Einstellmittel auf verschiedene Art und Weise miteinander kombiniert werden. So könnte beispielsweise ein Einstellmittel vorgesehen sein, mit dem die Verstärkung in einem Grobbereich eingestellt werden kann. Ein weiteres Einstellmittel könnte zur Einstellung des Feinbereichs vorgesehen sein. Dabei könnten auch unterschiedliche Arten von Einstellmittel Anwendung finden. So könnte beispielsweise der Grobbereich manuell eingestellt werden, während eine Feinabstimmung elektronisch durchgeführt wird.

Zum vorzugsweise automatisierten Einstellen der Impedanz könnte eine Einstelleinrichtung vorgesehen sein, die Steuersignale an die Einstellmittel ausgibt. Diese Steuersignale könnten zum einen als analoge Steuerspannungen oder -ströme ausgebildet sein, zum anderen könnten die Steuersignale digitale Signale umfassen. Auch hier sind wiederum die verschiedensten aus der Praxis bekannten Verfahren anwendbar. Die Wahl der Steuersignale und die Wahl der Einstellmittel werden jedoch sinnvollerweise aufeinander abgestimmt sein.

Vorzugsweise arbeitet eine Einstelleinrichtung im Wesentlichen automatisch. Dadurch kann durch die Schaltung automatisch die gewünschte Impedanz oder das gewünschte Verhalten eingestellt werden. Der Einstellvorgang könnte zum einen in Form einer Steuerung erfolgen. In diesem Fall würde beispielsweise eine gewünschte Impedanz vorgegeben und die Einstellmittel durch die Einstelleinrichtung entsprechend eingestellt. Die Entsprechung zwischen dem vorgegebenen Wert und der tatsächlichen Einstellung der Einstellmittel könnte zum einen durch die Schaltung selbst vorgegeben sein. Zum anderen könnte, insbesondere bei einer digitalen Steuerung, die Zuordnung in Form einer Zuordnungsvorschrift, beispielsweise als Zuordnungstabelle, ausgestaltet sein. Der gewünschte Wert könnte dabei auch indirekt vorgegeben werden. Beispielsweise beim Einsatz der Schaltung in einem LC-Schwingkreis könnte eine gewünschte Frequenz vorgegeben werden. Dieser Frequenz würde dann eine Einstellung des/der Einstellmittel entsprechend zugeordnet.

Vielfach ist eine automatisierte Einstellung jedoch wesentlich einfacher und präziser, wenn die Einstellung in Form einer Regelung ausgeführt wird. In diesem Fall könnte beispielsweise beim Einsatz der Schaltung in einem LC-Schwingkrels die durch den Schwingkreis ausgegebene Frequenz gemessen und mit einer vorgegebenen Sollfrequenz verglichen werden. Die Einstelleinrichtung passt die Einstellmittel dann so lange geeignet an, bis die Differenz zwischen der gewünschten Frequenz und der tatsächlich ausgegebenen Frequenz unterhalb einer vorgebbaren Schranke liegt.

Die Schaltung lässt sich vorteilhafter Weise im Zusammenhang mit der Anpassung der Resonanzfrequenz eines Schwingkreises einsetzen. Besondere Vorteile bietet dies beispielsweise im Zusammenhang mit der Ansteuerung eines Sensors. Handelt es sich bei dem Sensor beispielsweise um einen Wirbelstromsensor, der in einer Resonanzfrequenz betrieben werden soll, so kann die erfindungsgemäße Schaltung vorteilhafter Weise dazu genutzt werden, die Treiberschaltung auf die Resonanz des Sensors einzustellen. Auf diese Weise könnten sehr einfach und schnell Veränderungen der Resonanzfrequenz in Folge von Temperaturdrift, Bauteilalterung, Korrosion, Störgrößen oder dergleichen reagiert werden.

Andererseits könnte die erfindungsgemäße Schaltung auch im Zusammenhang mit dem Anpassen eines Ausgangs einer Treiberschaltung verwendet werden. In ein Kabel können Signale dann besonders effektiv eingekoppelt werden, wenn die Ausgangsimpedanz der Treiberstufe im Wesentlichen der Impedanz des angeschlossenen Kabels entspricht. Dies stellt bei fest mit dem Ausgang der Treiberschaltung verbundenen Kabeln keine Schwierigkeit dar, da hier die geeigneten Abschlussimpedanzen gut bestimmt und an geeigneten Stellen angebracht werden können. Können jedoch an eine Treiberschaltung verschieden lange Kabel angeschlossen werden, so müsste die Impedanz der Ausgangsstufe an das jeweils eingesetzte Kabel angepasst werden. Hier könnte die erfindungsgemäße Schaltung zum Einsatz kommen.

Darüber hinaus sind viele weitere Einsatzbereiche der erfindungsgemäßen Schaltung denkbar.

Es gibt nun verschiedene Möglichkeiten, die Lehre der vorliegenden Erfindung in vorteilhafter Weise auszugestalten und weiterzubilden. Dazu ist einerseits auf die dem Patentanspruch 1 nachgeordneten Patentansprüche und andererseits auf die nachfolgende Erläuterung von bevorzugten Ausführungsbeispielen der Erfindung anhand der Zeichnung zu verweisen. In Verbindung mit der Erläuterung der bevorzugten Ausführungsbeispiele der Erfindung anhand der Zeichnung werden auch im Allgemeinen bevorzugte Ausgestaltungen und Weiterbildungen der Lehre erläutert. In der Zeichnung zeigen - jeweils als Schaltbild -
- Fig. 1: den prinzipiellen Aufbau einer erfindungsgemäßen Schaltung zum Einstellen der Impedanz zwischen zwei Polen mit einem Pufferverstärker an jedem Pol,
- Fig. 2: den prinzipiellen Aufbau einer erfindungsgemäßen Schaltung ähnlich Fig. 1, wobei lediglich ein Pol über einen Pufferverstärker verfügt,
- Fig. 3: den Einsatz eines spannungsgesteuerten Verstärkers in einer erfindungsgemäßen Schaltung,
- Fig. 4: den Einsatz eines stromgesteuerten Verstärkers in einer erfindungsgemäßen Schaltung,
- Fig. 5: die Ausgestaltung des Einstellmittels als digitales Potentiometer,
- Fig. 6: den Einsatz einer erfindungsgemäßen Schaltung im Zusammenhang mit der Ansteuerung eines Wirbelstromsensors,
- Fig. 7: den Einsatz einer erfindungsgemäßen Schaltung entsprechend Fig. 6, wobei die Schaltung zusätzlich eine Detektionsvorrichtung umfasst und
- Fig. 8: den Einsatz einer erfindungsgemäßen Schaltung entsprechend Fig. 7, wobei die Schaltung automatisch einstellbar ausgestaltet ist.

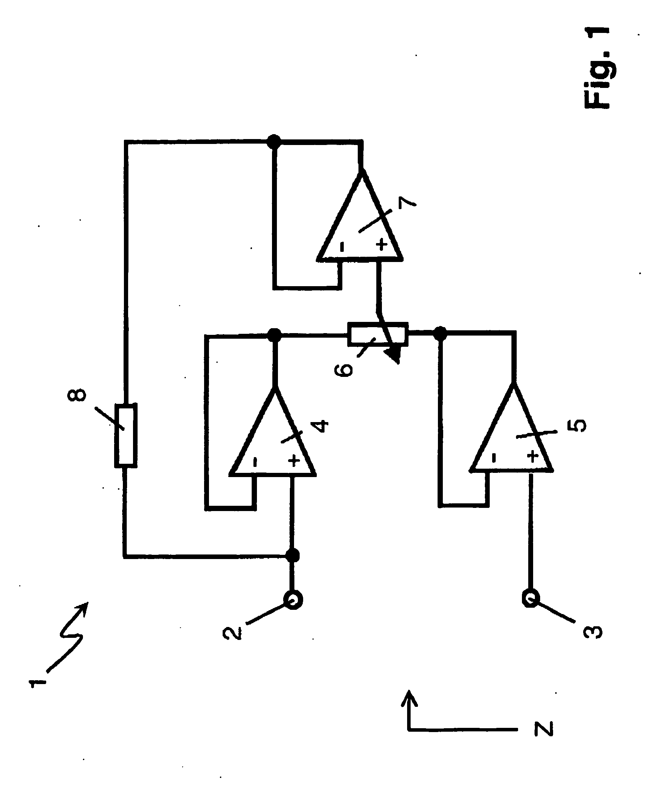

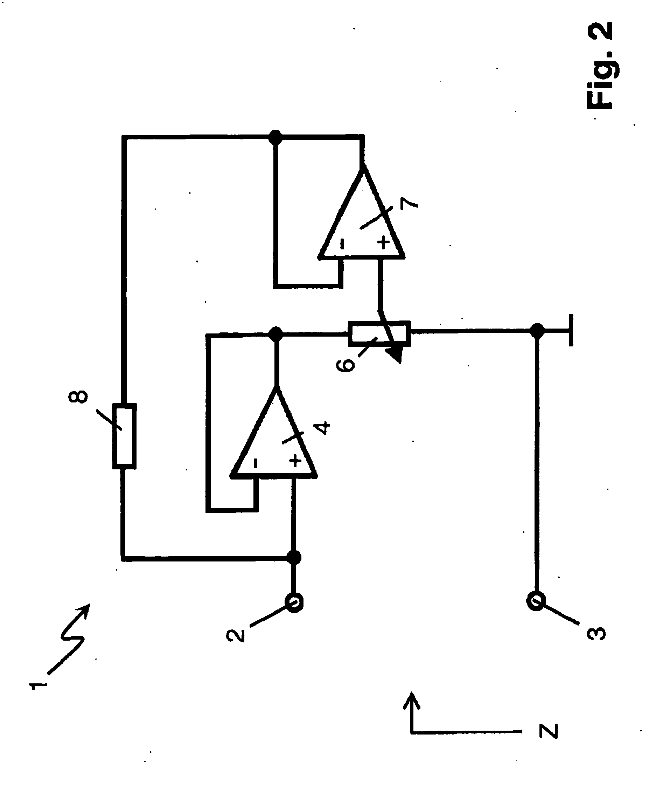

Fig. 1 und 2 zeigen den prinzipiellen Aufbau einer erfindungsgemäßen Schaltung 1 zum Einstellen der Impedanz Z zwischen zwei Polen 2, 3. Jeder der Pole 2, 3 ist in Fig. 1 mit jeweils einem Pufferverstärker 4 bzw. 5 verbunden, die als Impedanzwandler verschaltet sind. In Fig. 2 ist lediglich ein Pufferverstärker 4 vorgesehen, während ein in Pol 3 eingekoppeltes Signal direkt in die Schaltung eingespeist wird. Da Pol 3 auf Erdpotential liegt, kann der Pufferverstärker entfallen. Die Ausgänge der Pufferverstärker bzw. der direkt verbundene Pol sind in den Figuren 1 und 2 mit einem Potentiometer 6 derart verbunden, dass zwischen den beiden Anschlüssen der Nennwiderstand des Potentiometers 6 liegt. Der Schleifkontakt des Potentiometers 6 ist mit dem nicht-invertierenden Eingang eines Operationsverstärkers 7 verbunden. Bei allen eingesetzten Operationsverstärkern 4, 5, 7 wird der Ausgang jeweils direkt auf den invertierenden Eingang zurückgekoppelt. Der Ausgang des Operationsverstärkers 7 ist zusätzlich über eine Rückkopplungsimpedanz 8 mit dem Pol 2 verbunden. Je nach Einstellung des Potentiometers 6 wird die Verstärkung der Schaltung 1 zwischen 0 und 1 eingestellt. Wegen der allgemeinen Schwingungsneigung sind Verstärkungen größer 1 nicht sinnvoll. Durch die Veränderung der Verstärkung werden unterschiedlich große Anteile der Rückkopplungsimpedanz 8 für die Impedanz Z wirksam. Bei einer Verstärkung nahe 1 kann die Impedanz Z auf einen Minimalwert - idealerweise nahe 0 - und bei einer Verstärkung von etwa 0 annähernd auf den Wert der Rückkopplungsimpedanz 8 eingestellt werden. Da in der dargestellten Ausführung ein Potentiometer 6 verwendet wird und die Verstärkung kontinuierlich eingestellt werden kann, wird auch eine Einstellbarkeit der Impedanz in einem kontinuierlichen Wertebereich erreicht.

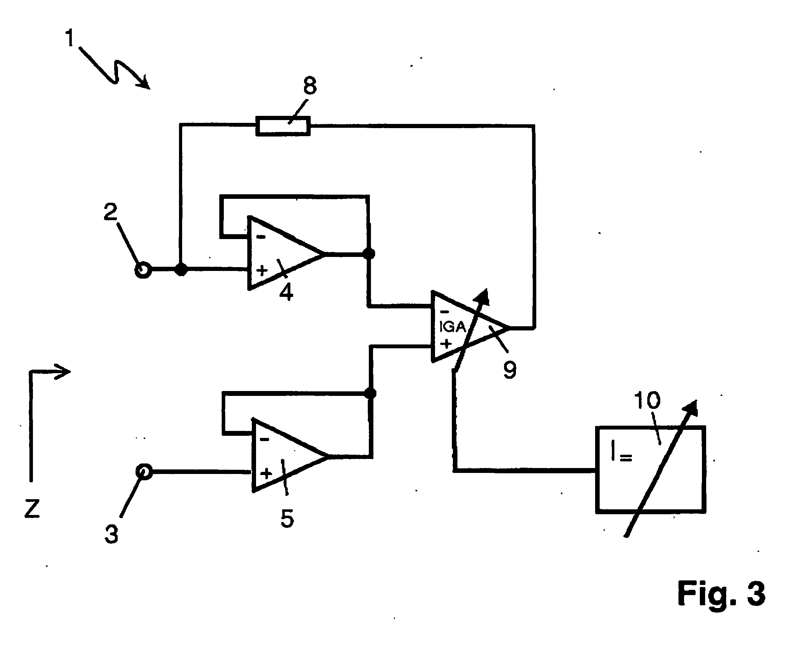

Fig. 3 zeigt einen vergleichbaren Aufbau wie Fig. 1. Lediglich wird hier das Potentiometer 6 und der darauf folgende Verstärker 7 durch einen stromgesteuerten Operationsverstärker 9 (IGA) ersetzt. Der Steuerstrom wird durch eine steuerbare Stromquelle 10 erzeugt. Die Stromquelle 10 kann dabei manuell, elektrisch, elektronisch oder digital einstellbar ausgestaltet sein.

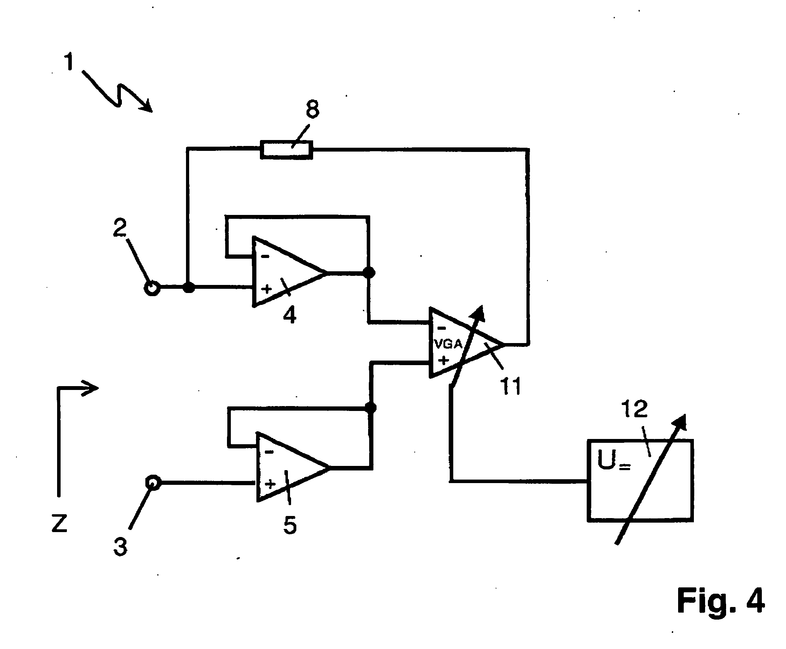

Den Einsatz eines spannungsgesteuerten Verstärkers 11 (VGA) zeigt Fig. 4. Das Steuersignal bildet hierbei die Ausgangsspannung einer einstellbaren Spannungsquelle 12. Auch diese Quelle kann auf die verschiedensten Arten einstellbar sein.

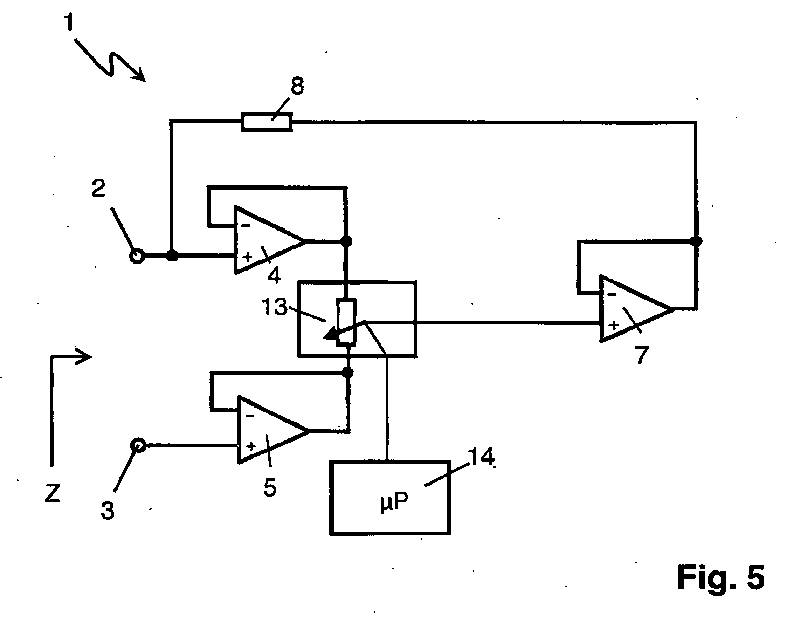

In Fig. 5 ist eine andere Ausgestaltung des Einstellmittels dargestellt. Der Aufbau der Schaltung 1 gleicht prinzipiell dem der Schaltung aus Fig. 1. Lediglich ist das Potentiometer 6 durch ein digitales Potentiometer 13 ersetzt, das von einem Mikroprozessor 14 über ein digitales Steuersignal eingestellt wird.

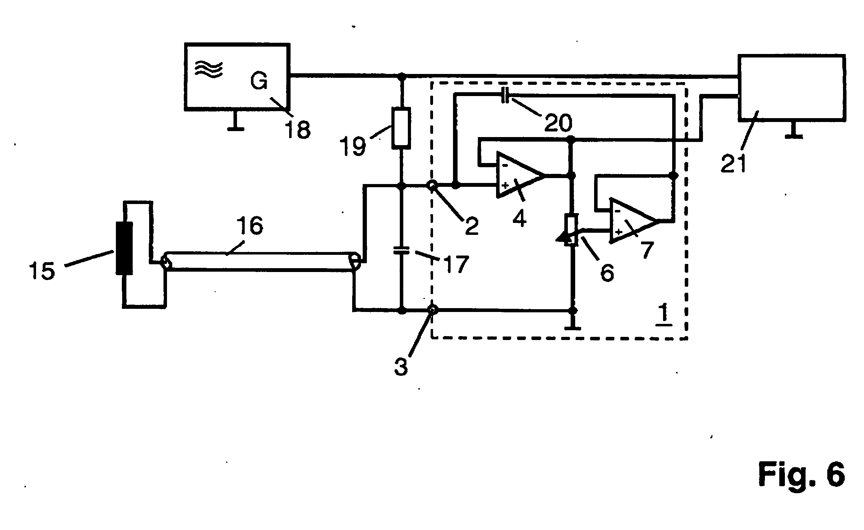

Die Figuren 6, 7 und 8 zeigen den Einsatz einer erfindungsgemäßen Schaltung 1 im Zusammenhang mit der Ansteuerung eines Sensors 15. Der dargestellte Sensor 15 sei Teil eines Wegmesssystems, das nach dem Wirbelstromverlustprinzip arbeitet. Dieser Sensor 15 soll In einer Resonanzfrequenz betrieben und auf dieser Frequenz gehalten werden, so dass in den Messbereich des Wirbelstromsensors 15 tretende leitende Gegenstände einen besonders großen Einfluss auf das Messsignal erzeugen. Dazu wird der Wirbelstromsensor 15 zusammen mit seinem Anschlusskabel 16 durch einen Kondensator 17 zu einem Schwingkreis ergänzt, der durch die Wahl der Werte der Bauteile auf eine Grundfrequenz vorabgeglichen ist. Der Schwingkreis wird durch einen Generator 18 mit Energie versorgt, wobei die Energie über eine Kopplungsimpedanz 19 in den Schwingkreis eingekoppelt wird. Parallel zu der Kapazität 17 ist eine erfindungsgemäße Schaltung 1 zum Einstellen einer Impedanz Z zwischen zwei Polen 2, 3 geschaltet. Da der Pol 3 auf Massepotential liegt, wird auf einen Pufferverstärker an diesem Pol verzichtet. Die verwendete Schaltung 1 gleicht also der in Fig. 2 dargestellten Schaltung. Die Rückkopplungsimpedanz wird durch eine Kapazität 20 gebildet.

Durch Einstellung des Potentiometers 6 wird die Verstärkung der Schaltung 1 und somit der für die Impedanz Z wirksame Anteil der Rückkopplungskapazität 20 eingestellt. Auf diese Weise kann die Gesamtkapazität der Parallelschaltung aus der Kapazität 17 und der Schaltung 1 verändert werden. Mit der Veränderung der Gesamtkapazität geht auch eine Veränderung der Resonanzfrequenz des aus Nährungssensor 15, Kabel 16, Kapazität 17 und Schaltung 1 bestehenden Schwingkreises einher. Bei einer Verstärkung nahe 1 wird ein minimaler Anteil der Rückkopplungsimpedanz 20 wirksam. Da die Frequenz eines Schwingkreises umgekehrt proportional zu der Wurzel aus der Kapazität ist, wird sich bei einer minimalen Kapazität eine maximale Resonanzfrequenz ergeben. Mit abnehmender Verstärkung nimmt der für die Impedanz Z wirksame Anteil der Rückkopplungskapazität 20 zu. Dadurch sinkt die Resonanzfrequenz des Schwingkreises bis auf ein Minimum. Durch geeignete Wahl der einzelnen Bauteile kann somit die Resonanzfrequenz in einem größeren Bereich verschoben werden.

Nach Einstellung der Schaltung wird das durch den Sensor 15 detektierte Signal durch eine Auswerteelektronik 21 je nach den messtechnischen Erfordernissen entsprechend ausgewertet.

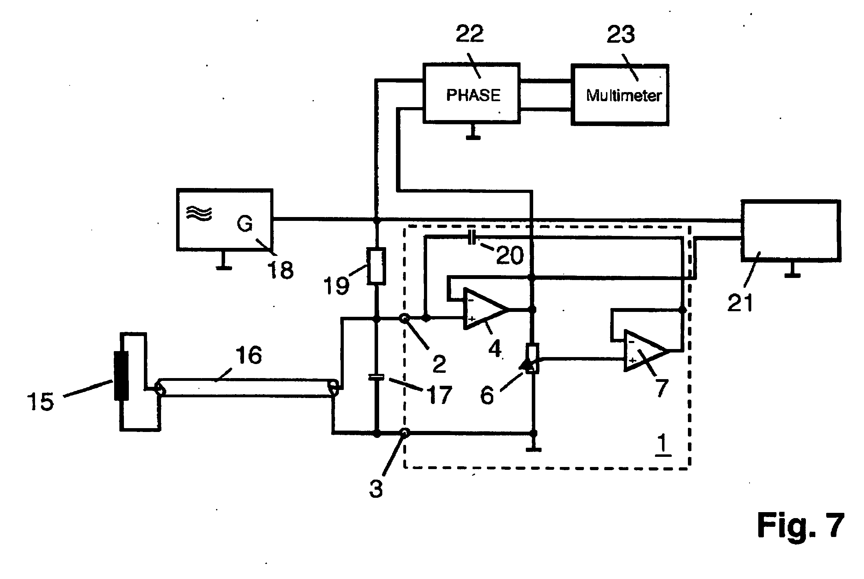

Die in Fig. 7 dargestellte Schaltung unterscheidet sich von der in Fig. 6 dargestellten Schaltung dadurch, dass die Phasendifferenz zwischen dem durch den Generator 18 ausgegebenen Signal und dem Signal des Schwingkreises aus Näherungssensor 15, Anschlusskabel 16, Kapazität 17 und Schaltung 1 bestimmt wird. Die durch den Phasenkomparator 22 bestimmte Phasendifferenz wird durch eine Anzeigeeinrichtung 23, die hier als Multimeter ausgestaltet ist, ausgegeben. Diese Phasendifferenz kann dazu genutzt werden, das Einstellmittel 6 solange anzupassen, bis die Differenz unterhalb einer vorgebbaren Schranke, beispielsweise nahe 0, liegt. In Fig. 7 erfolgt die Einstellung des Einstellmittels manuell.

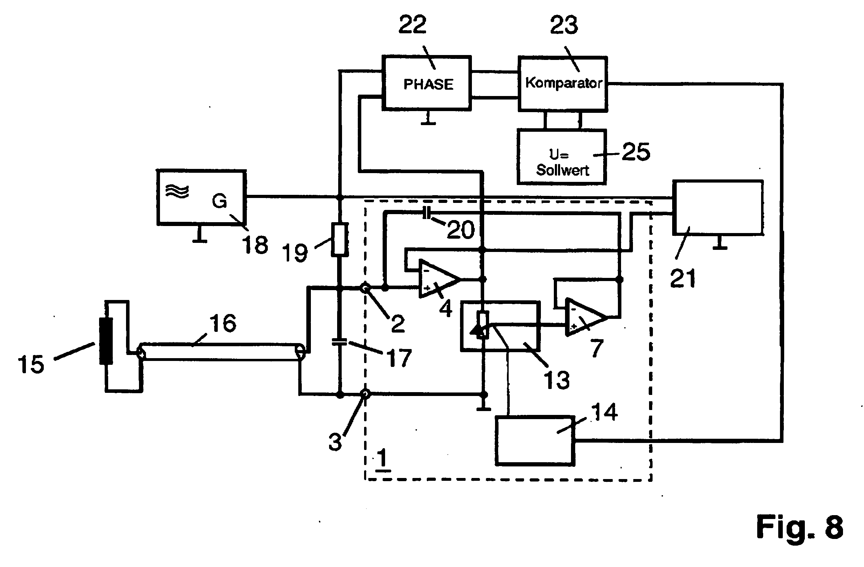

Fig. 8 zeigt eine Schaltung, bei der diese Anpassung automatisiert durchgeführt werden kann. Die Schaltung 1 wird dabei durch die in Fig. 5 dargestellte Schaltung gebildet, wobei wiederum auf den Puffverstärker 5 aus dem bekannten Grund verzichtet wird. Als Rückkopplungsimpedanz dient eine Kapazität 20. Ein Phasenkomparator 22 misst die Phasendifferenz zwischen dem durch den Generator 18 generierten Signal und dem Signal des aus Näherungssensor 15, Anschlusskabel 16, Kapazität 17 und Schaltung 1 bestehenden Schwingkreises. Der Ausgang des Phasenkomparators 22 wird einem weiteren Komparator 24 zugeführt, der das Differenzsignal mit einem Sollwert 25 vergleicht. Dieser Sollwert 25 wird im Allgemeinen einer Phasendifferenz von 0 entsprechen. Allerdings sind auch andere Sollwerte denkbar. Der Ausgang des Komparators 24 wird einem Mikroprozessor 14 als Eingangssignal zur Verfügung gestellt. Basierend auf das Komparationsergebnis zwischen Phasendifferenz und Sollwert stellt der Mikroprozessor 14 den digitalen Potentiometer 13 geeignet ein, so dass das von dem Komparator 24 empfangene Differenzsignal unterhalb einer vorgebbaren Schwelle zu liegen kommt.

Die in den Figuren 6, 7 und 8 dargestellten Schaltungen können jedoch auch dazu genutzt werden, dass der Einsatz von unterschiedlich langen Anschlusskabeln ermöglicht wird. Bisher existierende Wegmesssysteme, die nach dem Wirbelstromverlustprinzip arbeiten, weisen das Problem auf, dass die Kabellänge zwischen Sensor und zugeordneter Elektronik beschränkt ist. Dies liegt insbesondere darin begründet, dass bei einer gegebenen Arbeitsfrequenz die Kabelkapazität in Verbindung mit der Induktivität des Kabels selbst und der Induktivität des Sensors lediglich einen maximalen Wert annehmen darf. Die maximal zulässige Kabellänge ist erreicht, wenn die gesamte erforderliche Parallelkapazität im Kabel enthalten ist. Wenn die dann erreichte Länge für die Anwendung nicht ausreicht, kann durch eine zusätzliche Parallelinduktivität die Gesamtinduktivität verringert und somit die Resonanzfrequenz des Schwingkreises erhöht werden. Dadurch wird es möglich, das Sensorkabel weiter zu verlängern, um wieder die gewünschte Resonanzfrequenz zu erhalten.

Hierzu kann wiederum eine erfindungsgemäße Schaltung eingesetzt werden. Die gesamte Schaltung zur Ansteuerung des Sensors entspricht dabei den Schaltungen gemäß Figuren 6, 7 oder 8. In den Schaltungen muss lediglich die Rückkopplungskapazität 20 durch eine Rückkopplungsinduktivität ersetzt werden. Der Schwingkreis besteht wiederum aus dem Sensor, dem kapazitiven und induktiven Beitrag des Anschlusskabels 16, der Kapazität 17 und der durch die Schaltung 1 gebildeten Impedanz. Durch Verändern der Verstärkung der Schaltung 1 kann die Impedanz Z verändert. Bei einer Verstärkung nahe 1 ist ein minimaler Anteil der Rückkopplungsinduktivität wirksam, wodurch der Schwingkreis eine minimale Resonanzfrequenz annimmt. Durch Reduzieren der Verstärkung kann der für die Impedanz Z wirksame Anteil der Rückkopplungsinduktivität erhöht werden, wodurch die Resonanzfrequenz des Schwingkreises bis zu ihrem Maximum ansteigt. Somit kann beispielsweise eine Grundbestückung mit einer Kapazität 17, die für die richtige Resonanzfrequenz ohne Sensorkabel 16 erforderlich ist, erfolgen und je nach Länge des angeschlossenen Sensorkabels 16 wieder manuell oder automatisch auf die richtige Resonanzfrequenz durch Einstellen der Schaltung 1 abgeglichen.

Darüber hinaus könnte sowohl eine Schaltung 1 mit einer Rückkopplungskapazität als auch eine Schaltung 1 mit einer Rückkopplungsinduktivität vorgesehen sein. Auf diese Weise kann je nach Ansteuerung der Schaltungen die Resonanz nach oben oder nach unten verschoben werden.

Abschließend sei ganz besonders hervorgehoben, dass die zuvor erörterten Ausführungsbeispiele lediglich zur Erläuterung der beanspruchten Lehre dienen, diese jedoch nicht auf die Ausführungsbeispiele einschränken soll.

### Bezugszeichenliste

- 1: Schaltung
- 2: Pol (der Schaltung)
- 3: Pol (der Schaltung)
- 4: Operationsverstärker als Pufferverstärker
- 5: Operationsverstärker als Pufferverstärker
- 6: Potentiometer
- 7: Operationsverstärker
- 8: Rückkopplungsimpedanz
- 9: Operationsverstärker (IGA)
- 10: Stromquelle
- 11: Operationsverstärker (VGA)
- 12: Spannungsquelle
- 13: Digitales Potentiometer
- 14: Mikroprozessor
- 15: Sensor
- 16: Anschlusskabel
- 17: Kondensator
- 18: Generator (für Wechselspannung)
- 19: Kopplungsimpedanz
- 20: Kapazität (als Rückkopplungsimpedanz)
- 21: Auswerteschaltung
- Z: Impedanz

## Patentansprüche

1. Schaltung zum Einstellen einer Impedanz (Z) zwischen zwei Polen (2, 3), wobei die Impedanz (Z) die Eingangsimpedanz der Schaltung (1) ist, wobei die Schaltung (1) Verstärker (7, 9, 11) und Einstellmittel umfasst, wobei mittels des/der Einstellmittel die Verstärkung mindestens eines der Verstärker verändert werden kann, wobei durch Beeinflussen des/der Einstellmittel die Impedanz (Z) zwischen den beiden Polen (2, 3) veränderbar ist, wobei die Schattung (1) eine Rückkopplungsschleife mit einer Rückkopplungsimpedanz (8) aufweist und wobei durch Beeinflussen des/der Einstellmittel der für die Eingangsimpedanz der Schaltung wirksame Anteil der Rückkopplungsimpedanz (8) einstellbar ist,
**dadurch gekennzeichnet, dass** die Schaltung (1) Bestandteil eines Schwingkreises ist, dessen Schwingfrequenz oder Phasenlage durch Beeinflussen des/der Einstellmittel beeinflussbar ist.

2. Schaltung nach Anspruch 1, **dadurch gekennzeichnet, dass** die Rückkopplungsimpedanz (8) mindestens eine Kapazität (20) und/oder mindestens eine Induktivität aufweist.

3. Schaltung nach Anspruch 1 oder 2, **dadurch gekennzeichnet, dass** die Verstärkung zwischen 0 und 1 gewählt wird.

4. Schaltung nach einem der Ansprüche 1 bis 3, **dadurch gekennzeichnet, dass** die Verstärker (7, 9, 11) Operationsverstärker umfassen.

5. Schaltung nach einem der Ansprüche 1 bis 4, **dadurch gekennzeichnet, dass** das/die Einstellmittel manuell, elektronisch oder digital einstellbar ist/ sind.

6. Schaltung nach einem der Ansprüche 1 bis 5, **dadurch gekennzeichnet, dass** die Einstellmittel derart einstellbar sind, dass sich die Verstärkung kontinuierlich oder in Stufen verändert.

7. Schaltung nach einem der Ansprüche 1 bis 6, **dadurch gekennzeichnet, dass** ein Einstellmittel einen Potentiometer (6,13) umfassen.

8. Schaltung nach einem der Ansprüche 1 bis 7, **dadurch gekennzeichnet, dass** ein Einstellmittel zusammen mit einem zugeordneten Verstärker als strom- oder spannungsgesteuerter Verstärker (9, 11) ausgestaltet ist.

9. Schaltung nach einem der Ansprüche 1 bis 8, **dadurch gekennzeichnet, dass** ein Einstellmittel als multiplizierender Digital-Analog-Wandler ausgestaltet ist.

10. Schaltung nach einem der Ansprüche 1 bis 9, **dadurch gekennzeichnet, dass** eine Einstelleinrichtung (10, 12, 14) vorgesehen ist, die Steuersignale für die Einstellmittel ausgibt, wobei die Einstelleinrichtung (10, 12, 14) vorzugsweise eine im Wesentlichen automatische Einstellung der Einstellmittel vornimmt.

11. Schaltung nach Anspruch 10, **dadurch gekennzeichnet, dass** die Einstelleinrichtung (10, 12, 14) als Regelung ausgestaltet ist und/oder
dass eine gewünschte Eingangsimpedanz der Schaltung eingestellt wird.

12. Schaltung nach einem der Ansprüche 1 bis 11, **dadurch gekennzeichnet, dass** die Schaltung (1) im Zusammenhang mit der Ansteuerung eines Sensors (15) zum Einsatz kommt, wobei der Sensor (15) einen Wirbelstromabstandssensor umfassen kann.

13. Schaltung nach einem der Ansprüche 1 bis 12, **dadurch gekennzeichnet, dass** die Schaltung (1) zum Anpassen des Ausgangs einer Treiberschaltung (18, 19) an unterschiedliche mit dem Ausgang verbundene Impedanzen dient, wobei die unterschiedlichen mit dem Ausgang verbundenen Impedanzen durch unterschiedlich lange Kabel zu einem Sensor hervorgerufen werden können.

## Claims

1. A circuit for adjusting an impedance (Z) between two poles (2, 3), wherein the impedance (Z) is the input impedance of the circuit (1), wherein the circuit (1) comprises amplifiers (7, 9, 11) and adjusting means, wherein the gain of at least one of the amplifiers may be altered by means of the one or more adjusting means, wherein the impedance (Z) between the two poles (2, 3) is alterable by influencing of the one or more adjusting means, wherein the circuit (1) has a feedback loop with a feedback impedance (8) and wherein that proportion of the feedback impedance (8) which is effective for the input impedance of the circuit is adjustable by influencing of the one or more adjusting means,
**characterised in that** the circuit (1) is a component part of an oscillating circuit whose oscillating frequency or phase position may be influenced by influencing of the one or more adjusting means.

2. A circuit according to claim 1, **characterised in that** the feedback impedance (8) has at least one capacitance (20) and/or at least one inductance.

3. A circuit according to claim 1 or 2, **characterised in that** the gain is selected to be from 0 to 1.

4. A circuit according to any one of claims 1 to 3, **characterised in that** the amplifiers (7, 9, 11) comprise operational amplifiers.

5. A circuit according to any one of claims 1 to 4, **characterised in that** the one or more adjusting means is or are manually, electronically or digitally adjustable.

6. A circuit according to any one of claims 1 to 5, **characterised in that** the adjusting means are adjustable in such a manner that the gain changes continuously or in stages.

7. A circuit according to any one of claims 1 to 6, **characterised in that** an adjusting means comprises a potentiometer (6, 13).

8. A circuit according to any one of claims 1 to 7, **characterised in that** an adjusting means is configured together with an associated amplifier as a current-controlled or voltage-controlled amplifier (9, 11).

9. A circuit according to any one of claims 1 to 8, **characterised in that** an adjusting means is configured as a multiplying digital-to-analogue converter.

10. A circuit according to any one of claims 1 to 9, **characterised in that** an adjusting device (10, 12, 14) is provided which outputs control signals for the adjusting means, wherein the adjusting device (10, 12, 14) preferably carries out a substantially automatic adjustment of the adjusting means.

11. A circuit according to claim 10, **characterised in that** the adjusting device (10, 12, 14) is configured as a closed-loop controller and/or that a desired input impedance of the circuit is adjusted.

12. A circuit according to any one of claims 1 to 11, **characterised in that** the circuit (1) is used in connection with the actuation of a sensor (15), wherein the sensor (15) may comprise an eddy-current distance sensor.

13. A circuit according to any one of claims 1 to 12, **characterised in that** the circuit (1) serves to adapt the output of a driver circuit (18, 19) to different impedances connected to the output, wherein the different impedances connected to the output may be caused by different-length cables to a sensor.

## Revendications

1. Circuit destiné à régler une impédance (Z) entre deux pôles (2, 3), l'impédance (Z) étant l'impédance d'entrée du circuit (1), le circuit (1) comprenant des amplificateurs (7, 9, 11) et des moyens de réglage, l'amplification d'au moins l'un des amplificateurs pouvant être modifiée au moyen du/des moyens de réglage, l'impédance (Z) entre les deux pôles (2, 3) pouvant être modifiée par l'influence du/des moyens de réglage, le circuit (1) présentant une boucle de rétroaction comprenant une impédance de rétroaction (8) et la partie, efficace pour l'impédance d'entrée du circuit, de l'impédance de rétroaction (8) pouvant être réglée par l'influence du/des moyens de réglage,
**caractérisé en ce que** le circuit (1) est un composant d'un circuit oscillant, dont la fréquence d'oscillation ou la position de phase peut être influencée par l'influence du/des moyens de réglage.

2. Circuit selon la revendication 1, **caractérisé en ce que** l'impédance de rétroaction (8) présente au moins une capacité (20) et/ou au moins une inductance.

3. Circuit selon la revendication 1 ou 2, **caractérisé en ce que** l'amplification est choisie entre 0 et 1.

4. Circuit selon l'une des revendications 1 à 3, **caractérisé en ce que** les amplificateurs (7, 9, 11) comprennent des amplificateurs opérationnels.

5. Circuit selon l'une des revendications 1 à 4, **caractérisé en ce que** le/les moyens de réglage peut/peuvent être réglé(s) de façon manuelle, électronique ou numérique.

6. Circuit selon l'une des revendications 1 à 5, **caractérisé en ce que** les moyens de réglage peuvent être réglés de telle sorte que l'amplification soit modifiée de façon continue ou par niveau.

7. Circuit selon l'une des revendications 1 à 6, **caractérisé en ce que** les moyens de réglage comprennent un potentiomètre (6, 13).

8. Circuit selon l'une des revendications 1 à 7, **caractérisé en ce qu'**un moyen de réglage est conçu en même temps qu'un amplificateur associé comme amplificateur (9, 11) commandé par courant ou tension.

9. Circuit selon l'une des revendications 1 à 8, **caractérisé en ce qu'**un moyen de réglage est conçu comme convertisseur numérique-analogique multiplicateur.

10. Circuit selon l'une des revendications 1 à 9, **caractérisé en ce qu'**un dispositif de réglage (10, 12, 14) est prévu, lequel émet des signaux de commande pour les moyens de réglage, le dispositif de réglage (10, 12, 14) effectuant de préférence un réglage sensiblement automatique des moyens de réglage.

11. Circuit selon la revendication 10, **caractérisé en ce que** le dispositif de réglage (10, 12, 14) est conçu comme réglage et/ou
**en ce qu'**une impédance d'entrée souhaitée du circuit est réglée.

12. Circuit selon l'une des revendications 1 à 11, **caractérisé en ce que** le circuit (1) est utilisé en relation avec l'activation d'un capteur (15), le capteur (15) pouvant comprendre un capteur de distance de courant de Foucault.

13. Circuit selon l'une des revendications 1 à 12, **caractérisé en ce que** le circuit (1) sert à l'adaptation de la sortie d'un circuit driver (18, 19) à différentes impédances reliées à la sortie, les différentes impédances reliées à la sortie pouvant être provoquées par des câbles de longueur différente allant vers un capteur.
